# EUROPÄISCHE PATENTSCHRIFT

(11) **EP 0 520 323 B1**
(45) Veröffentlichungstag und Bekanntmachung des Hinweises auf die Patenterteilung: **11.12.1996**
(21) Anmeldenummer: 92110312.3
(22) Anmeldetag: 18.06.1992
(51) Int. Cl.: H05K 3/00, C25D 17/06, C25D 17/08

(54) **Vorrichtung zum Behandeln von plattenförmigen Gegenständen**
Apparatus for treating panel-type objects
Appareil pour traiter des objets de type panneaux

(30) Priorität: 26.06.1991 DE 4121079
(43) Veröffentlichungstag der Anmeldung: 30.12.1992
(73) Patentinhaber: Gebr. Schmid GmbH & Co., D-72250 Freudenstadt (DE)
(72) Erfinder: Kappler, Heinz, W-7295 Dornstetten-Asch (DE)
(74) Vertreter: Patentanwälte Ruff, Beier, Schöndorf und Mütschele

(56) Entgegenhaltungen:
- EP-A- 0 254 030
- EP-A- 0 406 534
- WO-A-92/15403
- US-A- 5 024 745

## Beschreibung

Die Erfindung betrifft eine Vorrichtung nach dem Oberbegriff des Patentanspruches 1. Sie ist zum Behandeln von plattenförmigen Gegenständen, insbesondere von Leiterplatten, geeignet. Die Vorrichtung gemäß der Erfindung ist zur Behandlung mit einem flüssigen Behandlungsmedium, insbesondere einer Reinigungs-, Ätz-, Metallisierungs- bzw. Spülflüssigkeit oder ähnlichem ausgebildet. Die Behandlung erfolgt entlang eines im wesentlichen horizontalen Transportweges, welcher durch eine Transportvorrichtung definiert ist.

Vorrichtungen dieser Art können z.B. Ätzvorrichtungen oder dgl. für elektrische Leiterplatten sein. Die Transportvorrichtung kann dabei durch einen Rollentisch gebildet sein, der die Transportebene definiert und über den die Platten in Transportrichtung bewegbar sind.

Bei der Herstellung von sogenannten Multi-Layer-Leiterplatten werden die einzelnen Schichten dieser Leiterplatten zweckmäßig einzeln den verschiedenen Reinigungs-, Ätz-, Metallisierungs- oder Spülprozessen unterzogen und erst in der fertig entwickelten Form zu der Multi-Layer-Platte zusammengefügt.

Um bei einer großen Zahl von einzelnen Schichten einer Multi-Layer-Platte die Dicke der Gesamtplatte nicht zu groß werden zu lassen, werden die Schichtdicken der einzelnen Schichten der Multi-Layer-Platte bei steigender Integrationsdichte ständig verringert. Die Platten weisen dabei keine ausreichende Steifigkeit für den üblichen Transport mehr auf, so daß die vorauslaufende Kante der Platte nicht immer exakt in der durch den Rollentisch definierten Transportebene verweilt, sondern sich wölbt und von dieser dann abweicht.

Dadurch kann es immer wieder zu Störungen im Plattentransport kommen, weil durchgebogene oder aufgewölbte Platten an Teilen der Transportvorrichtung anstoßen und zurückgehalten werden.

In der US-A-5 024 745 werden zu behandelnde Gegenstände durch Randklammerung gehalten und so durch einen Behandlungsbereich hindurchgeführt. Die Klammern laufen in Transportrichtung mit. Hier sind besondere Maßnahmen zur Klammerschließung und Klammeröffnung an Anfang und Ende des Transportes notwendig. Auch die EP-A 0254030 beschreibt eine ähnliche Klammerhalterung.

Die WO-A-92/15403, die nach dem Prioritätstag des vorliegenden Patentes veröffentlicht ist, zeigt im Behandlungsbereich keine Stützung oder Führung der Gegenstände. Der Behandlungsbereich zur Beschichtung der Platten ist sehr kurz. Die Führung der plattenförmigen Gegenstände erfolgt nur in Transportrichtung vor und nach dem Behandlungsbereich. Die Führung geschieht durch beidseitige, im Randbereich angreifende scharfkantige Scheiben oder Stachelbänder.

Der Erfindung liegt die Aufgabe zugrunde, Nachteile bekannter Ausbildungen bzw. der beschriebenen Art zu verringern und insbesondere eine Vorrichtung zum Behandeln von plattenförmigen Gegenständen vorzuschlagen, mit der bevorzugt solche dünnen Leiterplatten entlang ihres Transportweges sicher gehandhabt werden können.

Diese Aufgabe wird bei einer Vorrichtung der genannten Art erfindungsgemäß durch die Ansprüche 1 und 4 gelöst.

Es hat sich überraschend herausgestellt, daß eine Unterstützung der flexiblen Leiterplatten oder Schichten einer Multi-Layer-Platte im mittleren Bereich entfallen kann, wenn die Längskanten der Platten und die dazu parallel verlaufenden Randbereiche unterhalb und oberhalb der Transportebene durch derartige Führungselemente (Bänder oder Führungstische mit Rollen) geführt werden.

Diese Führung reicht aus, um zu verhindern, daß die vorlaufende Kante, insbesondere in ihren Eckbereiche, sich wölbt und den Weitertransport der Leiterplatte behindert oder sogar verhindert.

Es ist auch möglich, zusätzlich zwischen den beidseits des Transportweges angeordneten Führungselementen eine Unterstützung für die Leiterplatten in Form einer Rollenbahn vorzusehen.

Da die Behandlungsmedien auf die Leiterplatte in der Regel durch Sprühen, Schwallen und ähnliches aufgebracht werden, und da im Vordergrund selbstverständlich eine gleichmäßige Behandlung der gesamten interessierenden Leiterplattenfläche steht, muß darauf geachtet werden, daß die Rollen der Rollenbahnen nicht zu große Bereiche der zu behandelnden Fläche der Leiterplatten abdecken.

Die Gefahr einer ungleichmäßigen Behandlung der Leiterplatten an ihrer Unterseite wird insbesondere dann vermindert, wenn die Rollen der Rollenbahn, die in Reihen quer zu dem Transportweg angeordnet sind, bezüglich der Rollen der in Transportrichtung vorhergehenden Reihe seitlich versetzt angeordnet werden. Dadurch ist die Zeitspanne, in der ein Flächeninkrement der Platte von den Rollen der Rollenbahn abgedeckt wird, relativ gering, so daß sich diese kurzzeitige Abdeckung am Behandlungsergebnis der Plattenunterseite nicht bemerkbar macht.

Die Führungselemente der Transportvorrichtung können so ausgebildet sein, daß sie den Rand der Platten erfassen und abdecken, da häufig eine Behandlung der Platten im Randbereich nicht erforderlich ist.

Bei der Verwendung von Führungstischen sorgen diese dafür, daß die vorauseilende Kante im Bereich der vorderen Ecken der Leiterplatte mit nur geringen Toleranzen in der Transportebene gehalten wird, während die Rollen, die vorzugsweise in regelmäßigen Abständen in den Ausnehmungen der Tische angeordnet sind, verhindern, daß die Leiterplatte über die Führungstischebene schleift.

Gleichzeitig können die Rollen angetrieben sein, so daß sich dadurch der Transport der Leiterplatten in Transportrichtung bewerkstelligen läßt.

Bei der Verwendung von Bändern zur Führung der Leiterplattenkanten können diese so ausgebildet sein, daß sie für das Behandlungsmedium durchlässig oder undurchlässig sind.

Im Falle, daß eine Durchlässigkeit für das Behandlungsmedium besteht, wird der Effekt der Abdeckung der Randbereiche entlang der Längskanten der Platten vermindert, und eine bestimmte Behandlung der Leiterplattenoberfläche findet auch in dem Bereich statt, in dem sie von den Bändern erfaßt werden.

Im Falle der Verwendung von mediumundurchlässigen Bändern erhält man praktisch keine Behandlung der Ränder der Leiterplatten. Und falls dies insbesondere wünschenswert ist, kann durch ein Anwalzen der Bänder an die Platte sichergestellt werden, daß die Verbindung zwischen Band und Platte so eng wird, daß ein gewisser Klebeeffekt entsteht, der zudem verhindert, daß ein Flüssigkeitsaustausch in dem Bereich zwischen Band und Platte stattfinden kann.

In solchen Fällen wird bevorzugt eine Konstruktion gewählt, bei der die Führungselemente mit endlos umlaufenden Bändern sowohl oberhalb als auch unterhalb der Transportebene angeordnet sind.

Hierbei ist es allerdings ausreichend, wenn nur die Bänder unterhalb oder oberhalb der Transportebene antreibbar sind.

Aufgrund der Abdeckwirkung der Bänder und der Behinderung des Zutritts von Behandlungsflüssigkeit werden die Bänder in der Regel mit ihrer Breite so bemessen, daß sie lediglich die nicht zu behandelnden Randbereiche der Platten abdecken und erfassen.

Um einen gleichmäßigen Transport der Platten durch die Vorrichtung sicherzustellen, wird das einzelne Endlosband so dimensioniert, daß es sich mit seinem der Transportebene zugewandten Trum im wesentlichen über den gesamten Transportweg innerhalb der Vorrichtung erstreckt. Eine Übergabe von einem Bandtransportsystem an das nächste wird damit innerhalb der Vorrichtung vermieden.

Bei der Verwendung der Bänder als Führungselemente ist es wichtig, daß diese an der für sie vorgesehenen seitlichen Position des Transportweges verbleiben und nicht in Richtung zur Mitte der Transportebene hin auswandern.

Überraschend hat sich herausgestellt, daß es für eine exakte Führung der Endlosbänder ausreichend ist, wenn sie lediglich an ihrem der Transportebene abgewandten Trum seitlich geführt werden. Die Führung des abgewandten Trums wird vorteilhafterweise mit einer Spannvorrichtung ergänzt, die beispielsweise in Form einer federbelasteten Leerlaufrolle bestehen kann.

Die Führungselemente mit den Endlosbändern können problemlos mit den Führungselementen in Form von Führungstischen kombiniert werden, wobei die Führungstische unterhalb der Transportebene und die Endlosbänder als Führungselemente oberhalb der Transportebene angeordnet werden.

Soll auch der Randbereich einer definierten Behandlung unterzogen werden, die vergleichbar mit der der Plattenmitte ist, so werden bevorzugt in die Führungstische auf ihrer der Transportebene zugewandten Seite über ihre gesamte Breite reichend RückSprünge eingebracht, die den Rollen aufnehmenden Ausnehmungen, in Transportrichtung gesehen, nachfolgend angeordnet sind. Die Rücksprünge in den Führungstischen erlauben, daß ein Behandlungsmedium mit der Oberfläche der Leiterplatte im Randbereich in Berührung kommt, so daß eine Behandlung auch dieses Bereichs der Leiterplatte gewährleistet ist.

Vorzugsweise weisen diese Rücksprünge eine sägezahnartige Form auf, wobei eine zunächst stufenartige Rücksetzung bezüglich der Transportebene sich im wesentlichen direkt an die in Transportrichtung vorhergehende Ausnehmung anschließt und wobei eine sich an die Stufe anschließende flach ansteigende Fläche in Richtung zur Transportebene zurückführt.

Es hat sich im Hinblick auf die Vermeidung von Totwasserzonen als günstig herausgestellt, die Kantenbereiche der Rücksprünge stark zu verrunden.

Diese spezielle Ausbildung der Rücksprünge in den Führungstischen führt dazu, daß selbst dann, wenn die vordere Kante der Leiterplatten im Bereich des Rücksprunges etwas aus der Transportebene abweichen sollte, die Kante allmählich beim Transport selbsttätig wieder zur Transportebene zurückgeführt wird, bevor die nächste in einer Ausnehmung des Führungstisches angeordnete Rolle mit der vorauslaufenden Kante der Leiterplatte in Kontakt kommt.

Die Abstände zwischen den aufeinanderfolgenden Rücksprüngen werden bevorzugt so klein wie möglich gehalten, so daß ein möglicher Kontakt der in Transportrichtung bewegten Leiterplatten mit der Führungstischoberfläche soweit wie möglich vermieden wird. Dadurch lassen sich unerwünschte Bremseffekte der Leiterplatten beim Transport auf ein Minimum begrenzen. Da die am nächsten zur Transportebene angeordneten Bereiche der Führungstische auf solche Abschnitte des Transportweges beschränkbar sind, in denen die in den Ausnehmungen angeordneten Rollen für eine Anhebung der Leiterplatten zumindest im Rand- und Führungstischbereich sorgen, wird damit gleichzeitig ein Maximum an Störunanfälligkeit des Transportsystems erreicht. Ein Verkanten der Leiterplatten in der Transportvorrichtung wegen unterschiedlicher Fortbewegungsgeschwindigkeiten beidseits des Transportweges ist damit so gut wie ausgeschlossen.

Obwohl zwischen zwei aufeinander folgenden, mit Rollen bestückten Ausnehmungen der Führungstische mehrere Rücksprünge möglich sind, wird bevorzugt zwischen zwei Ausnehmungen nur ein Rücksprung angeordnet. Dies vereinfacht nicht nur die Konstruktion der Führungstische, sondern erlaubt auch relativ flache Steigungen der in Richtung zur Transportebene zurückführenden Flächen der sägezahnartig ausgebildeten Rücksprünge. Andererseits bleibt die dem Rücksprung gegenüberliegende Fläche des Randbereiches der Platte auf einer relativ langen Strecke frei und damit für die Behandlung mit dem Behandlungsmedium zugänglich.

Die Führungstische als Führungselemente lassen sich sowohl unterhalb als auch oberhalb der Transportebene verwenden, wobei dann die Behandlung der Randbereiche der Platten sowohl an der Unter- als auch an der Oberseite möglich ist.

Die Abstände der Ausnehmungen der Führungstische können unterhalb und oberhalb der Transportebene gleich gewählt werden. Dabei liegen sich jeweils die in den Ausnehmungen angeordneten Rollen bezüglich der Transportebene gegenüber.

Vorzugsweise wird jedoch der Abstand der Ausnehmungen der Führungstische bei den oberhalb der Transportebene angeordneten Führungstischen größer gewählt als bei den unterhalb der Transportebene liegenden, da die Behandlung der Leiterplatten an ihrer Oberseite stets kritischer ist als an ihrer Unterseite, beispielsweise durch ein Rückstauen der Behandlungsflüssigkeit, so daß sich unerwünscht unterschiedliche Behandlungszeiten für einzelne Bereiche der Leiterplatten ergeben.

Vorzugsweise ist der Abstand der Ausnehmungen bei den Führungselementen oberhalb der Transportebene etwa doppelt so groß wie der Abstand in den Führungstischen, die unterhalb der Transportebene verwendet werden. Die Rücksprünge mit den flach ansteigenden Flächen überdecken damit bei den oberhalb der Transportebene angeordneten Führungstischen etwa den doppelten Bereich wie die unterhalb der Transportebene vorkommenden. Dadurch resultiert eine gleichmäßigere Drainage an der Oberseite, die die zuvor angesprochenen Probleme der Behandlung der Oberseite vermeidet.

Des weiteren ist es vorteilhaft, wenn die Ausnehmungen der oberhalb der Transportebene angeordneten Führungstische und die darin gehaltenen Rollen im wesentlichen auf die Ausnehmungen in den unterhalb angeordneten Führungstischen ausgerichtet sind, so daß die Rollen in den Ausnehmungen im wesentlichen parallele, sich bezüglich der Transportebene gegenüberliegende, in einer gemeinsamen vertikalen Ebene angeordnete Drehachsen aufweisen.

Vorzugsweise werden die in den Ausnehmungen der unteren Führungstische angeordneten Rollen gleichzeitig auch zum Transport der Leiterplatten genutzt und zumindest teilweise angetrieben.

Ferner kann vorgesehen sein, daß die den Ausnehmungen zugehörenden Öffnungen in der der Transportebene zugewandten Seite der Führungstische so bemessen sind, daß bei eingesetzten Rollen nur noch relativ kleine Spalte zwischen den Rollen und den Führungstischen verbleiben. Diese Ausbildung wird auch bei sehr dünnen Leiterplatten zuverlässig verhindern, daß die vorauslaufenden Kanten und Ecken der Leiterplatten sich im Bereich der Ausnehmungen an den Führungstischen verfangen.

Vorzugsweise wird die Breite der Rollen bzw. ihrer Umfangsfläche kleiner gewählt als die Breite der Führungstische, wobei dann die den Ausnehmungen zugehörenden Öffnungen vorteilhafterweise ringsum von der der Transportebene benachbart liegenden Fläche der Führungstische umgeben sind. Einmal in die Ausnehmung und die Öffnungen eingesetzte Rollen erhalten dadurch bereits die notwendige seitliche Führung. Zum anderen wird die Breite der Führungselemente weniger kritisch, da ja die Leiterplatte von den Führungstischen im Bereich der Rollen leicht abgehoben wird, so daß an dieser Stelle ein Zutritt der Behandlungsflüssigkeit möglich ist.

Somit lassen sich beispielsweise bei Wegfall der Rollenbahnen im Bereich zwischen den seitlichen Führungselementen die Führungstische zumindest unterhalb der Transportebene etwas breiter gestalten, um auch bei vergleichsweise dünnen Platten noch eine ausreichende Stützung der Platte und damit ein Entgegenwirken gegen ein Durchbiegen der Platten zu erreichen, ohne daß das Behandlungsergebnis in Frage gestellt wird.

Ferner läßt sich der Abschirmeffekt durch das Aufliegen der Platten auf den Rollenumfang dadurch vermindern, daß die Umfangsfläche der in den Ausnehmungen der Führungstische angeordneten Rollen strukturiert werden, d.h. insbesondere regelmäßige Erhebungen bzw. Vertiefungen aufweisen. Dadurch wird von den Rollen Behandlungsflüssigkeit mitgeschleppt und gegen die Oberfläche der Platte gefördert bzw. gleichzeitig der Flüssigkeitsfilm an der jeweiligen Oberfläche der Platte ausgetauscht. Eine weitere Verbesserung des Behandlungsergebnisses im Randbereich bei besonders kritischen Fällen wird dadurch erreicht, daß die Rollen der Führungstische in wechselnden Abständen - von der Mitte der Transportebene gesehen - angeordnet sind, wodurch sich für den einzelnen Randbereich der Platte bei gleicher Beabstandung der nacheinander folgenden Rollen innerhalb der Führungstische eine verringerte Abdeckwirkung ergibt.

In weniger kritischen Fällen wird man allerdings wegen der einfacheren Herstellungsmöglichkeit die Ausnehmungen und Öffnungen in den Führungstischen im wesentlichen in derselben seitlichen Position anbringen, wenn dies von dem zu behandelnden Plattenmaterial bzw. dem durchzuführenden Behandlungsschritt her möglich ist.

Die erfindungsgemäße Vorrichtung ist zwar hauptsächlich dazu ausgelegt, besonders dünne Leiterplatten zu behandeln, jedoch ist von der maximalen Dicke her keine Grenze gesetzt, insbesondere dann, wenn die oberhalb der Transportebene angeordneten Führungselemente in Abhängigkeit von der Dicke der zu behandelnden Platten anhebbar sind.

Dies kann beispielsweise sinfach dadurch geschehen, daß ein Sensor, beispielsweise ein mechanischer Fühler, für die Dicke der neu in die Vorrichtung einlaufende Platte verwendet wird, der zu einer Anhebung der oberen Führungselemente führt. Andere Arten der Erkennung der Plattendicke der in die Vorrichtung einlaufenden Platten für die Justierung des Abstandes der oberhalb und unterhalb der Transportebene befindlichen Führungstische sind im Sinne der Erfindung auch geeignet.

Die erfindungsgemäße Vorrichtung kann zum einen mit einem fixen seitlichen Abstand der beidseits des Transportweges angeordneten Führungselemente konstruiert sein. Eine solche Vorrichtung ist für eine standardmäßige Plattengröße bzw. Plattenbreite gedacht und erlaubt nur relativ geringe Variationen in dieser Richtung, da sonst die Führungsfunktion der Führungselemente zumindest auf einer Seite verloren gehen könnte.

Andererseits läßt sich die erfindungsgemäße Vorrichtung auch mit einem variablen seitlichen Abstand der Führungselemente beidseits des Transportweges bauen, wobei zumindest ein Führungstisch in seinem seitlichen Abstand zur Transportwegmitte einstellbar ist. Damit wird die Möglichkeit geschaffen, mit einem relativ geringen konstruktiven Aufwand die Vorrichtung an verschiedene Leiterplattenbreiten anzupassen.

Die fakultativ zwischen den beidseits des Transportweges angeordneten Führungselementen vorgesehenen Rollenbahn wird vorzugsweise geringfügig tiefer angeordnet als die Führungselemente, so daß die durch die Rollenbahn definierte Ebene, in der die Leiterplatten gestützt werden können, etwas niedriger liegt als die durch die Führungselemente definierte Führungsebene bzw. Transportebene für die Leiterplatten.

Eine solche Vorrichtung ist im Falle, daß Leiterplatten mit einer relativ großen Steifigkeit behandelt werden, gleichwertig mit einer Vorrichtung, bei der die Rollenbahn entfernt ist, da die Rollen der Rollenbahn einen Abstand zu der Leiterplattenoberfläche einhalten, so daß keine merkliche Beeinflußung der Anströmung der Unterseite der zu behandelnden Leiterplatte vorkommt. Andererseits lassen sich mit derselben Vorrichtung auch relativ dünn gewählte Leiterplatten behandeln, da diese bei einer leichten Durchbiegung in der Mitte des Transportweges durch die Rollenbahn, soweit wie nötig, gestützt werden. Unter 'geringfügig tiefer' kann man bereits einen Abstand im zehntel Millimeter-Bereich verstehen, wobei beispielsweise bei der Verwendung von Endlosbändern bei den unterhalb der Transportebene angeordneten Führungselementen bereits eine Banddicke von ca. 0,5 mm für die Beabstandung zu der Ebene, die durch die mittlere Rollenbahn definiert wird, ausreichend ist.

Die früher bereits angesprochenen Endlosbänder können im Prinzip aus beliebigen Materialien sein, solange sie mit den Behandlungsmedien verträglich sind und eine ausreichende Formstabilität für den Betrieb der Vorrichtung aufweisen. Als besonders geeignetes Material hat sich glasfaserverstärktes Teflon-Band herausgestellt. Die Bänder werden zunächst lose montiert und erhalten ihre Spannung durch eine auf das der Transportebene abgewandte Trum wirkende Spannvorrichtung.

Die Spannvorrichtung kann beispielsweise federbelastet sein oder die Spannkraft über eine Hebelwirkung mit einem variablen Gewicht erzeugen.

Vorzugsweise werden die Bänder auf seiten ihres der Transportebene benachbarten Trums von Rollen gestützt. Die Breite der Endlosbänder wird dabei bevorzugt kleiner oder gleich der Breite der Umfangsfläche der Rollen gewählt. Dadurch wird in den Fällen, in denen der Randbereich der Leiterplatte von dem Band abgedeckt werden soll, so daß im wesentlichen keine Behandlung des Randbereichs durch die Behandlungsflüssigkeit geschieht, quasi die Bänder an die Oberfläche der Leiterplatte angewalzt und bleiben dort durch einen Kapillareffekt kleben.

Durch die regelmäßige Wiederkehr der Rollen wird der Kontakt der Endlosbänder mit der Plattenoberfläche gesichert, so daß ein unbeabsichtigtes Abheben des Bandes während des Durchlaufens durch die Vorrichtung vermieden wird.

Neben den bereits zuvor erwähnten Möglichkeiten der Aufbringung der Behandlungsflüssigkeit auf die Oberflächen der Leiterplatten besteht eine bevorzugte Ausführungsform darin, daß eine stehende Welle vorhanden ist, welche das flüssige Behandlungsmedium stetig gegen eine Oberfläche der Platte fördert. Unter einer stehenden Welle kann hierbei eine Düsenanordnung verstanden werden, welche einen kontinuierlichen Flüssigkeitsstrom, der allenfalls unwesentliche Gasanteile enthält, ständig gegen die Oberfläche der Platte fördert, so daß sich ein Flüssigkeitskontinuum von der Düsenanordnung bis zur Plattenoberfläche erstreckt.

Eine besonders bevorzugte Form der stehenden Welle ist in einem kontinuierlich überlaufenden und kontinuierlich wiederaufgefüllten Bad zu sehen, durch welches die Leiterplatten unterhalb oder direkt an der Flüssigkeitsoberfläche gefördert werden. Das Bad wird - in Transportrichtung gesehen - beim Einlauf und beim Auslauf bevorzugt durch selbstschließende Abdichtungen begrenzt, die den Durchtrittsspalt für die Leiterplatten schließen, wenn die Leiterplatte ganz in das Bad eingelaufen bzw. aus diesem heraustransportiert wurde.

In solchen Fällen steht eine vollständig definierte Behandlungsstrecke für die Leiterplatte zur Verfügung, und die Intensität der Behandlung hängt nur noch im wesentlichen von der Transportgeschwindigkeit der Leiterplatten durch die Vorrichtung ab, da sich allein durch die Längsausdehnung der Vorrichtung in Transportrichtung sowie die Transportgeschwindigkeit die Behandlungsdauer exakt einstellen läßt.

Vorzugsweise wird bei dieser Ausführungsform eine Konstruktion gewählt, bei der Führungselemente beidseits des Transportweges gleichzeitig eine obere seitliche Begrenzung definieren, welche zwischen sich und der durchlaufenden Platte einen oder mehrere Austrittsöffnungen, insbesondere Spalte, für das Behandlungsmedium schaffen. Dadurch wird erreicht, daß der Anteil der Behandlungsflüssigkeit im Bereich der Führungselemente ständig mit der Wiederauffüllung des Bades ausgetauscht wird, so daß auch in diesem Bereich ständig frisches bzw. wiederaufbereitetes Behandlungsmedium für den jeweiligen Behandlungsvorgang zur Verfügung steht.

Im Einlaufbereich der Transportvorrichtung empfiehlt es sich, keilförmig angeordnete Führungsflächen beidseits des Transportweges vorzusehen. Damit werden neu in die Vorrichtung einlaufende Leiterplatten mit ihrer vorlaufenden Kante automatisch auf die Transportebene der Vorrichtung zentriert, ohne daß bei der vorhergehenden Vorrichtung gesondere Vorkehrungen für ein exaktes Einspeisen der Leiterplatten in die nachfolgende Vorrichtung getroffen werden wüssen.

Der Übergang von einer Vorrichtung zur nächsten wird insbesondere bei den typischerweise modulartig aufgebauten Gesamtanlagen dadurch erleichtert, daß die keilförmig angeordneten Führungsflächen der Führungstische zumindest teilweise aus dem Gehäuse der Vorrichtung herausstehen und dadurch bei der Ankoppelung an ein vorhergehendes Modul in dieses hineinreichen können. Die hierdurch mögliche Überlappung der beiden Transportvorrichtungen vom vorherigen und nachfolgenden Modul sorgen für einen störungsarmen Übergang von der einen Transportvorrichtung zur nächsten.

Diese und weitere Vorteile der Erfindung werden im folgenden anhand der Zeichnung noch näher erläutert. Es zeigen im einzelnen:
- Figur 1: einen Längsschnitt durch eine erfindungsgemäße Vorrichtung;
- Figur 2: eine Schnittansicht durch eine andere Ausführungsform der Erfindung;
- Figur 3: eine Schnittansicht durch die Vorrichtung von Figur 1 längs Linie 3-3;
- Figur 4: eine Detailansicht eines Führungselementes der Ausführungsform gemäß Figur 2;
- Figur 5: eine teilweise aufgebrochene Seitenansicht einer alternativen Ausführungsform;
- Figur 6: eine Draufsicht auf ein Detail der Ausführungsform in Figur 5
und
- Fig. 7: eine Schnittansicht durch einen Modulübergang der Vorrichtung.

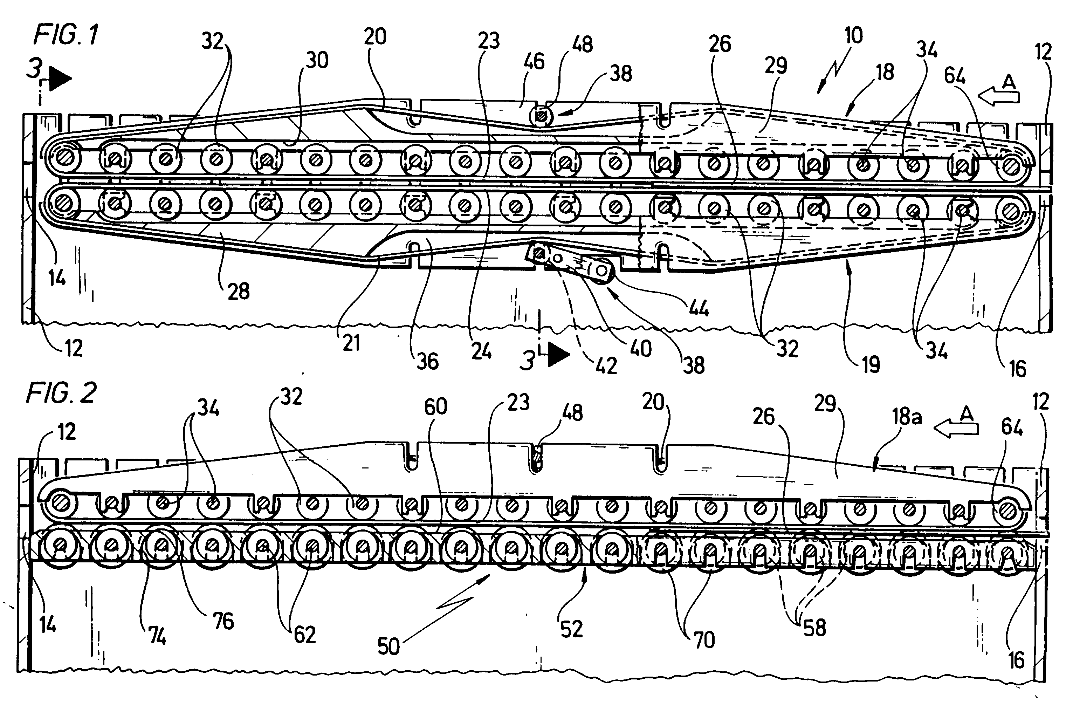

Die in Figur 1 gezeigte Vorrichtung ist insgesamt mit dem Bezugszeichen 10 bezeichnet. Die Figur 1 enthält der Übersichtlichkeit und Einfachheit halber nur die für die Erfindung wichtigsten Bestandteile.

Die Gesamtvorrichtung 10 wird durch eine Gehäusewandung 12 begrenzt, die auf ihrer Einlaufseite eine Eintrittsöffnung 14 und an ihrer Auslaufseite eine Austrittsöffnung 16 aufweist. Die Ein- und Austrittsöffnungen 14, 16 werden durch Abdichtungselemente z.B. Dichtlippen oder Klappen (nicht dargestellt) abgedichtet, die verhindern, daß ungewollt Behandlungsflüssigkeit aus dem Gehäuse 12 in die Umgebung austritt.

Die Transportvorrichtung der Gesamtvorrichtung 10 umfaßt beidseits des Transportweges und sowohl unterhalb als auch oberhalb der Transportebene Führungselemente 18, 19, welche Endlosbänder 20, 21 umfassen.

Die Endlosbänder 20, 21 sind so dimensioniert, daß sie sich mit ihrem der Transportebene gegenüberliegenden Trum 23, 24 jeweils entlang des gesamten Transportweges durch die Vorrichtung 10 erstrecken.

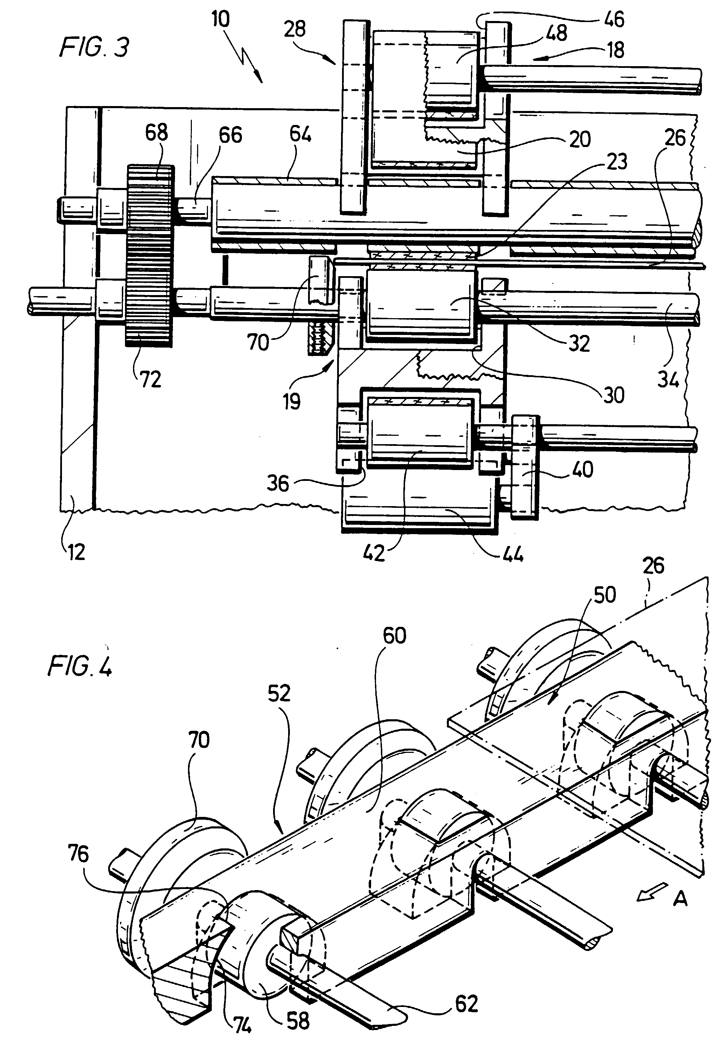

Die Bänder 20, 21 werden angetrieben (der Antrieb wird noch näher im Zusammenhang mit den Figuren 3 und 4 beschrieben) und dienen damit gleichzeitig dem Transport der Leiterplatten 26 durch die Vorrichtung. Das Führungselement 19, das unterhalb der Transportebene für die Leiterplatten 26 angeordnet ist, umfaßt einen langgestreckten schmalen Grundkörper 28, der auf seiner der Transportebene zugewandten Seite eine kanalförmige im Querschnitt rechteckige, in Richtung zur Transportebene hin vollständig offene Ausnehmung 30 aufweist (vgl. Figur 3). In diesem Kanal 30 sind in regelmäßigen Abständen Rollen 32 angeordnet, die das die Transportebene definierende Endlosband 21 an seinem Obertrum 24 stützen.

In den Seitenwandungen des Kanals 30 sind Bohrungen bzw. Ausnehmungen vorgesehen, in denen die Rollen 32 tragende Wellen 34 gehalten sind. Die Wellen 34 können sich über die gesamte Breite des Transportweges erstrecken und in dem bezüglich des Transportweges gegenüberliegenden Grundkörper des unteren Führungselementes wieder abgestützt sein. Dies ermöglicht gleichzeitig die Montage von weiteren Rollen in dem Bereich des Transportweges zwischen den seitlichen Führungselementen und die Ausbildung einer Rollenbahn (nicht dargestellt). Die Durchmesser der Rollen der Rollenbahn können dabei identisch gewählt werden wie die der in dem Führungskanal 30 angeordneten, da bereits die Stärke des Bandes einen ausreichenden Abstand der Umfangsflächen der Rollen der Rollenbahn zu der Transportebene gewährleistet, der sicherstellt, daß bei ausreichend steifen Platten kein Berührungskontakt mit der Plattenoberfläche auftritt. Bei mechanisch wenig stabilen Leiterplatten, d.h. solchen, die schon durch ihr Eigengewicht eine Durchbiegung erfahren, verhindern die Rollen eine zu große Abweichung von der Transportebene.

An dieser Stelle sei betont, daß das Endlosband 21 auf seiten seines Trums 24, das benachbart zur Transportebene angeordnet ist, keinerlei Führung erhält. Die Führung des Endlosbandes 21 wird durch eine kanalartige Vertiefung in dem Grundkörper 28 gewährleistet, die sich auf der der Transportebene abgewandten Seite des Grundkörpers befindet. Die kanalartige Vertiefung oder der Führungskanal 36 für das der Transportebene abgewandte Trum des Endlosbandes 21 erweitert sich im mittleren Teil des Grundkörpers 28 (in Transportrichtung gesehen), so daß das Band 21 über einen Bereich, der beispielsweise ein Drittel bis ein Viertel des der Transportebene abgewandten Trums ausmachen kann, freiliegend, d.h. von dem Grundkörper 28 nicht gestützt, geführt ist.

In diesem Bereich wird eine Spannvorrichtung 38 vorgesehen. Die Spannvorrichtung kann beispielsweise eine federbelastete Andruckrolle umfassen oder, wie in Figur 1 gezeigt, einen exzentrisch verschwenkbar gehaltenen Kipphebel 40, der an einem kürzeren Arm eine Schlepprolle 42 hält, während am längeren Arm ein Gewicht 44 angebracht ist, welches für den notwendigen Anpreßdruck für die Schlepprolle 42 und die Spannung des Bandes 21 sorgt.

Die Führung des Bandes 21 in der kanalartigen Vertiefung 36 auf der der Transportebene abgewandten Seite des Körpers 28 reicht aus, um dem Band an seinem Obertrum eine ausreichende Richtungsstabilität zu geben.

Oberhalb der Transportebene ist ein dem Grundkörper 28 korrespondierender Grundkörper 29 angeordnet, der das Band 20 im Bereich des Obertrums ebenfalls durch eine kanalartige Vertiefung 46 führt, in der das Obertrum des Bandes 20 über einen größeren Bereich hin ohne Unterstützung der kanalartigen Führung verläuft und durch das Gewicht einer auf dem Band aufliegenden Schleppwalze 48 gespannt wird. Es könnte auch an dieser Stelle eine federbelastete oder anders geartete Spannvorrichtung angebracht werden. Für die Montage und die Wartung der Vorrichtung ist dies jedoch die vorteilhafteste Art.

Die in Figur 2 dargestellte weitere Ausführungsform der Gesamtvorrichtung ist mit dem Bezugszeichen 50 versehen, wobei sich diese Ausführungsform von der in Figur 1 gezeigten im wesentlichen dadurch unterscheidet, daß lediglich die Führungselemente oberhalb der Transportebene ein Endlosband umfassen, während die Führungselemente unterhalb der Transportebene Führungstische beinhalten.

Während die Führung der Leiterplatten an ihrer Oberseite durch das Band wie im Falle der in Figur 1 dargestellten Vorrichtung erfolgt, kommt eine Führung der Leiterplattenkanten an deren Unterseite durch einen im wesentlichen ebenen, langgestreckten Tisch zustande, der eine Vielzahl von in regelmäßigen Abständen angeordnete Öffnungen aufweist, die eine Verbindung zu Ausnehmungen bilden, in denen Rollen 58 angeordnet sind, die mit ihrem Umfang nur wenig über die Tischebene 60 hinausragen. Die Rollen 58 sind auf Wellen 62 drehbar gehalten, welche eine Führung in dem Tischkörper 52 erhalten.

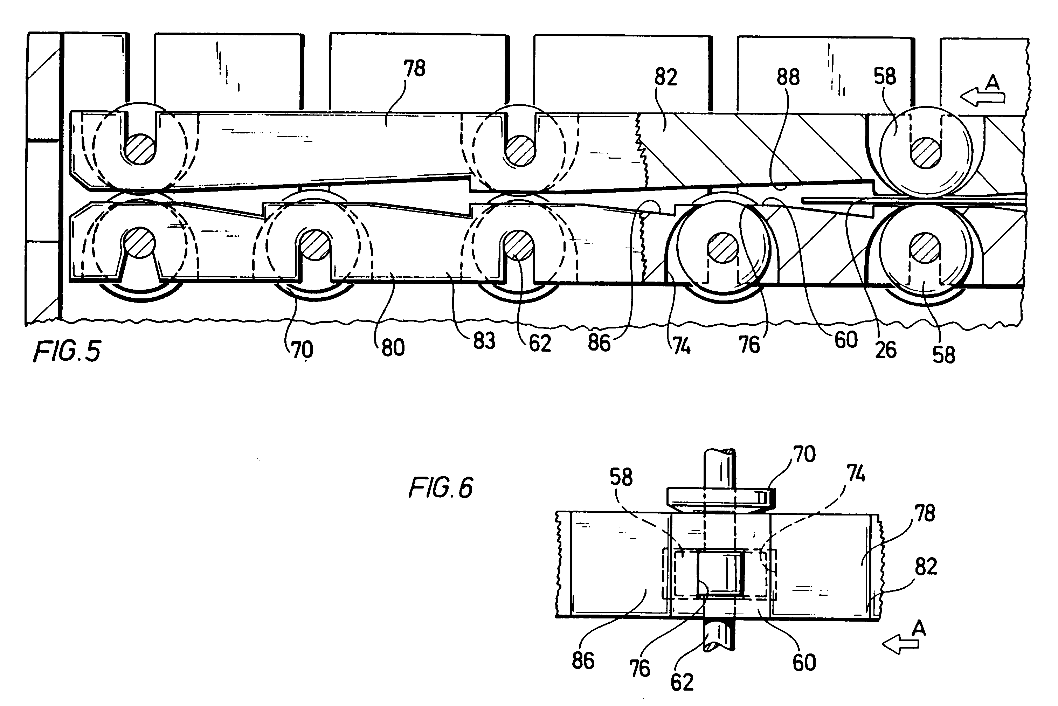

Eine genaue Beschreibung dieser Ausführungsform findet im Zusammenhang mit der Diskussion der Ausführungsform, die in Figur 5 dargestellt ist, statt.

Figur 3 zeigt den Aufbau und die Funktionsweise der Ausführungsform gemäß Figur 1 und der Führungselemente 18, 19, die oberhalb und unterhalb der Transportebene angeordnet sind, im Detail. Das Führungselement 18 entspricht auch dem Führungselement 18 a oberhalb der Transportebene in Figur 2, so daß die hier gegebenen Erläuterungen auch hierfür zutreffend sind.

Das obere Führungselement 18 ist dabei mit der einlaufseitigen Umlenkwalze 64 gezeigt, über die das Band 20 eingangsseitig umgelenkt wird. Die Walze 64 wird von einer Welle 66 drehfest gehalten, und die Welle 66 trägt an ihrem der Gehäusewandung 12 benachbarten Ende ein Ritzel 68, über das die Umlenkwalze 64 und damit auch das Endlosband 20 antreibbar ist.

Das Führungselement 18 umfaßt ferner den Grundkörper 29, der im Schnitt im Bereich des Einlaufbereichs der Gesamtvorrichtung 10 gezeigt ist. Das Obertrum des Bandes 20 wird von dem Körper 29 in Richtung zum auslaufseitigen Ende der Vorrichtung leicht ansteigend beidseitig geführt und verläuft in diesem Teil in einer kanalartigen Vertiefung 46 mit im wesentlichen rechteckigem Querschnitt.

Aufgrund der teilweise aufgebrochenen Darstellung ist die Schleppwalze 48 sichtbar, die mit ihrem Gewicht für die Spannung des Bandes 20 sorgt.

Die Welle der Schleppwalze 48 ist dabei in einer Schlitzführung gehalten, die ein Ausweichen der Schleppwalze nach oben erlaubt.

Nach einer Umlenkung des Bandes 20 über die Umlenkwalze 64 mündet das Band 20 mit seinem Untertrum 23 in die Transportebene ein und kommt dort auf einem Randbereich der Leiterplatte 26 zu liegen.

Da zwischen den beiden Endlosbändern 20 und 21 ein Spalt definiert ist, der im wesentlichen der Dicke der Leiterplatte 26 entspricht, kommt das Band direkt auf der Oberfläche der Leiterplatte zum Anliegen, und durch das Auspressen der eventuell vorhandenen Flüssigkeit ergibt sich ein gewisser Adhäsionseffekt. Diese Haftung der Oberfläche der Platine 26 an den Bändern 20 und 21 ist für einen sicheren, zeitlich nicht verzögerten Transport der Leiterplatte durch die Vorrichtung ausreichend.

Das gegenüber dem Führungselement 18 angeordnete Führungselement 19 ist in Figur 3 in Schnittansicht im Bereich des mittleren Teiles der Vorrichtung gezeigt.

Hierbei wird das Obertrum 24 des Bandes 21 von der Rolle 34 gestützt und gegen die untere Oberfläche der Platine 26 zur Anlage gebracht.

Die gezeigte Rolle 34 ist, wie die restlichen Rollen 34 ebenfalls, in einer kanalartigen Vertiefung 30 gehalten, die sich im wesentlichen über die gesamte Länge des Führungselements 19 erstreckt.

Die Rolle 32 wird dabei mittels der Welle 34 drehbar gelagert, welche sich in den Wandungen der kanalartigen Vertiefung 30 abstützt.

Die Welle 34 kann so ausgebildet sein, daß sie über die Außenseite des Führungselementes 19 hinausreicht, wobei dann auf diesem nach außen abstehenden Teil der Welle 34 sogenannte Abstandsscheiben 70 aufsetzbar sind, welche verhindern, daß die Leiterplatte beim Transport ungewollt von der eigentlichen Transportrichtung abweicht.

Ferner ist bei der Schnittdarstellung der Figur 3 die Spannvorrichtung für das Band 21 zu sehen, welche, wie zuvor erwähnt, aus einem einfachen Kipphebelmechanismus mit der Schlepprolle 42 und dem Gewicht 44 besteht, die an einem exzentrisch gelagerten Hebel 40 angeordnet sind.

Im Einlaufbereich ist die Welle 34 der Einlaufwalze 64 so verlängert, daß sie ein mit dem Ritzel 68 kämmendes Ritzel 72 tragen kann. Mit der Welle 34 wird die Antriebskraft für die Bänder eingeleitet und über das Ritzel 72 sowie das damit kämmende Ritzel 68 auf die obere Umlenkwalze und damit auf das Band 20 übertragen.

Figur 4 zeigt ein Detail eines Führungstisches, wie er in der Ausführungsform gemäß Figur 2 für das untere Führungselement verwendet wurde.

Der Führungstisch weist eine Tischoberfläche 60 auf, die im wesentlichen eben ist und der Führung der Vorderkanten der Leiterplatten 26 beim Durchlauf durch die Vorrichtung dient. In dem Führungstisch 52 sind von der Oberseite zur Unterseite durchgehende Ausnehmungen 74 vorgesehen, welche im Bereich der Tischoberfläche 60 eine im wesentlichen rechteckige Öffnung 76 definieren. Innerhalb der Ausnehmungen 74 sind die Rollen 58 gehalten, und zwar derart, daß sie mit ihrer Umfangsfläche nur wenig über die Tischoberfläche 60 hinausragen, andererseits jedoch die rechteckige Öffnung 76 möglichst vollständig ausfüllen, so daß zwischen der durch die Öffnung 76 durchtretenden Umfangsfläche der Rolle 58 und den Rändern der Öffnung 76 nur ein relativ geringer Spalt verbleibt.

Auf den nach außen über das Führungselement hinausstehenden Wellen sind wiederum Abstandsscheiben 70 angeordnet, welche verhindern, daß die Leiterplatten aus dem Bereich der Behandlungszone bzw. des Transportweges herauslaufen.

Die in Figur 4 gezeigte Ausführungsform der Führungselemente ist bereits für eine Reihe von Anwendungen geeignet, wobei allerdings keine allzu große Genauigkeit in der Bearbeitungsqualität der Randbereiche gefordert werden darf.

Sollen die Randbereiche einer im wesentlichen gleichen Behandlung durch die Behandlungsflüssigkeit unterzogen werden, wie dies im Falle der mittleren Teile der Leiterplatte geschieht, so wird bevorzugt eine Ausführungsform der Führungstische verwendet, wie dies in Figur 5 dargestellt ist. Die Führungstische 78, 80 in Figur 5 entstammen einer Ausführungsform, wo sowohl unterhalb als auch oberhalb der Transportebene die Führungselemente aus Führungstischen gebildet werden.

Um einen besseren Zutritt der Behandlungsflüssigkeit zu dem Randbereich der Oberflächen der Leiterplatten 26 zu erzielen, werden die Grundkörper 82, 83 in den Bereichen zwischen zwei aufeinander folgenden Rollen 58 mit einem Rücksprung versehen, der in Transportrichtung (Pfeil A) gesehen, zunächst von der Tischoberfläche 60 stufenartig und im wesentlichen im rechten Winkel zurücktritt, während die sich daran anschließende Leitfläche 86 mit einer geringen Steigung dem normalen Niveau der Tischebene 60 nähert.

Durch diese Ausgestaltung der Grundkörper 82, 83 wird erreicht, daß die Plattenoberflächen der Platte 26 kurz nach dem Kontakt mit einer Rolle 58 dem freien Behandlungsmedium ausgesetzt werden, während die sich an den Rücksprung anschließende Fläche eventuell aus der Transportebene abweichende vorlaufende Kanten der Leiterplatten wieder langsam auf das Niveau der Tischebene 60 zurückführt, wo sie dann von der nächstfolgenden Rolle 58 aufgenommen und weitergeleitet werden.

Da in der Regel die Behandlung der obenliegenden Plattenseite der Leiterplatte 26 kritischer ist, kann vorgesehen werden, daß der Abstand der Rollen und damit auch die Dimensionierung der Rücksprünge 88 bei den Führungselementen, die oberhalb der Transportebene angeordnet sind, größer ausfällt, so daß über einen größeren Zeitraum ein freier Zutritt des Behandlungsmediums zur Plattenoberfläche gewährleistet ist.

Figur 5 zeigt darüber hinaus eine besonders einfache Konstruktion der Führungselemente, bei denen die Grundkörper 82 lediglich über die auf Wellen befestigten Rollen, die drehbar von der Gesamtvorrichtung abgestützt sind, aufgesetzt werden, wobei die für den Durchtritt der Wellen vorgesehenen Ausnehmungen im Grundkörper den Wellen eine ausreichende Führung geben. Die oberen Führungselemente werden derart montiert, daß zunächst der Grundkörper 82 in die Vorrichtung eingesetzt wird und nachfolgend die Rollen 58, die bereits auf ihren Wellen montiert sind. Diese einfache und keine gesonderte Befestigung benötigende Montage bringt eine exzellente Wartungsfreundlichkeit mit sich, da die Einzelteile beispielsweise bei Verschleiß oder extremer Verschmutzung im wesentlichen ohne die Verwendung von Werkzeug aus der Vorrichtung entnommen bzw. wieder eingesetzt werden können. Dies gestattet eine ausgezeichnete Reaktionszeit im Falle von Störungen und führt zu einer sehr hohen Verfügbarkeit der Anlage.

Figur 6 schließlich zeigt noch einmal einen Führungstisch 83 in Draufsicht, wobei die Rücksprünge 86 sich deutlich sichtbar über den wesentlichen Teil des Zwischenbereichs zwischen zwei aufeinander folgenden Rollen 58 erstrecken.

Die Rücksprünge 86 und 88, die in die Tischoberfläche 60 eingebracht sind, dienen gleichzeitig dem seitlichen Abführen der Behandlungsflüssigkeit, wodurch sich ein besonders intensiver Austausch und die Bereitstellung von stets erneuerter Behandlungsflüssigkeit im Randbereich der zu behandelnden Leiterplatten ergeben.

Normalerweise werden Leiterplatte in einer Gesamtanlage in mehreren Schritten unterschiedlichen Behandlungsprozessen unterzogen und demgemäß wird die Gesamtanlage modulartig aus Einzelvorrichtungen zusammengestellt.

Bevorzugt werden innerhalb der einzelnen Module gleiche oder ähnliche Transportsysteme verwendet und auch sonst die Module soweit als möglich identisch aufgebaut.

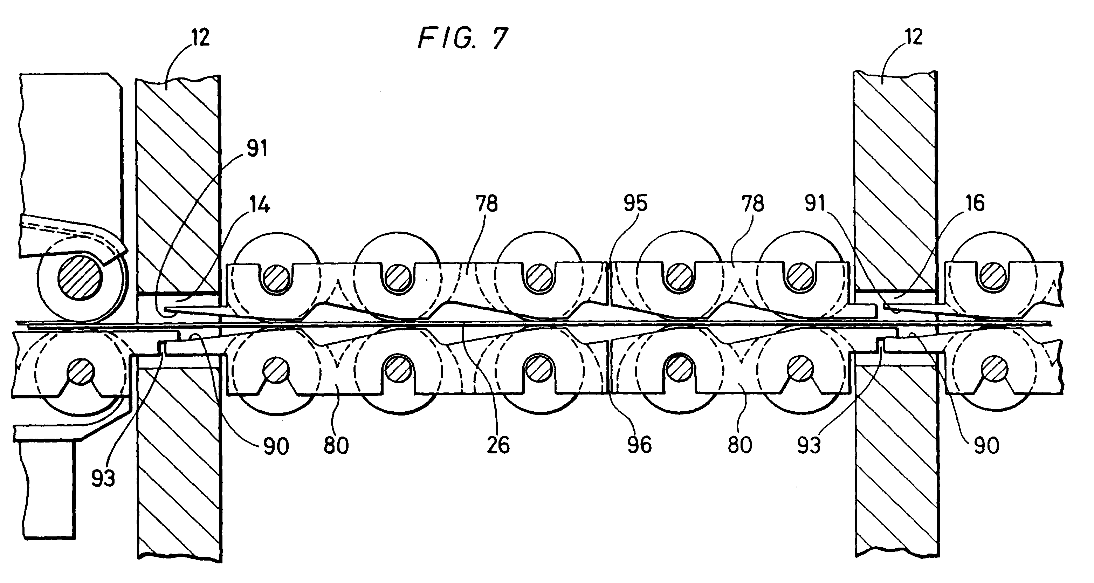

Um den Übergang von Modul zu Modul bzw. Vorrichtung zu Vorrichtung zu erleichtern, wird, wie in Fig. 7 gezeigt, vorgesehen, daß die Führungstische an ihrem einlaufseitigen Ende keilförmig ausgebildete Führungsflächen oberhalb und unterhalb der Transportebene sowie beidseits des Transportweges aufweisen, so daß sich für die vorlaufende Kante der einlaufenden Leiterplatte 26 eine automatische Zentrierung auf die Transportebene ergibt.

Das auslaufseitige Ende einer Vorrichtung oder eines Moduls wird so angepaßt, daß zumindest bei der Tischvorrichtung unterhalb der Transportebene über einen Absatz 93 eine Überlappung mit der keilförmigen Fläche 90 des nachfolgenden Moduls möglich ist.

In dieser Weise läßt sich ein beliebig verlängerbarer Transportweg für die Leiterplatten durch die Gesamtanlage aufbauen, ohne daß es an den Übergangsstellen von Modul zu Modul oder Vorrichtung zu Vorrichtung zu bereichsweisen Bremseffekten und Verzögerungen der Platten und damit einem Verkanten innerhalb der Vorrichtung kommen kann.

Es lassen sich auch die Transportvorrichtungen mit den Führungstischen 78, 80 innerhalb einer Vorrichtung modulartig aufbauen, wobei sich dann zwischen den Führungstischmodulen Nahtstellen 95, 96 ergeben, wie dies in Fig. 7 gezeigt ist. Die Behandlung von Leiterplatten in horizontalen Durchlaufanlagen bedingt eine konstante Transportgeschwindigkeit der Leiterplatten durch die Gesamtanlage, so daß chemische oder physikalische Prozesse, die eine längere oder kürzere Zeitdauer gemessen an der sonstigen Standardbehandlungszeit benötigen, eine Verlängerung bzw. Verkürzung der einzelnen Vorrichtung bzw. des einzelnen Moduls verlangen.

Mit den geteilten Führungstischen innerhalb eines Moduls kann diesem Bedürfnis leicht Rechnung getragen werden, ohne daß die Lagerhaltung für die Einzelteile der Transportwege einen großen Umfang annehmen muß.

## Patentansprüche

1. Vorrichtung zum Behandeln von plattenförmigen Gegenständen (26), insbesondere Leiterplatten, mit einem flüssigen Behandlungsmedium, wie einer Reinigungs-, Ätz-, Metallisierungs- und/oder Spülflüssigkeit, im Bereich eines, insbesondere im wesentlichen horizontalen, Transportweges, welcher durch eine Transportvorrichtung mit zugehöriger Transportbewegung definiert ist, wobei die Transportvorrichtung im Behandlungsbereich beiderseits der Transportebene die Gegenstände (26) führende Führungselemente (18, 19 bzw. 18a) umfaßt, dadurch gekennzeichnet, daß die Führungselemente (18, 19) mindestens ein endlos umlaufendes Band (20, 21) umfassen, das mit seinem Ober- oder Untertrum (23, 24) wenigstens einen parallel zu den Längskanten verlaufenden Randbereich der Gegenstände (26) abdeckt und erfaßt.

2. Vorrichtung nach Anspruch 1, dadurch gekennzeichnet, daß das Band (20, 21) antreibbar ist und daß insbesondere Bänder (20, 21) oberhalb und unterhalb der Transportebene angeordnet sind und daß vorzugsweise die Breite der Bänder (20, 21) so bemessen ist, daß sie lediglich nicht zu behandelnde Randbereiche der Gegenstände (26) abdecken und erfassen und/oder daß sich die Bänder (20, 21) mit ihrem der Transportebene zugewandten Trum (23, 24) im wesentlichen über den gesamten Transportweg innerhalb der Vorrichtung (10) erstrecken bzw. daß die Bänder (20, 21) nur an ihrem von der Transportebene abgewandten Trum seitlich geführt sind.

3. Vorrichtung nach Anspruch 1 oder 2, dadurch gekennzeichnet, daß das Band (20, 21) ein glasfaserverstärktes Teflon-Band ist und/oder daß das Band (20, 21) auf seiten seines der Transportebene benachbarten Trums (23, 24) von Rollen (32) gestützt ist bzw. die Breite des Bandes (20, 21) kleiner oder gleich der Breite der Umfangsfläche der Rollen (32) ist.

4. Vorrichtung nach dem Oberbegriff des Anspruchs 1, dadurch gekennzeichnet, daß die Führungselemente (18, 19) einen unterhalb und/oder oberhalb der Transportebene langgestreckten Führungstisch (52) zum Führen der Vorderkanten der Gegenstände aufweisen, der in zur Transportebene offenen Ausnehmungen (74) Rollen (58) enthält, die drehbar und mit ihrer Umfangsfläche nur geringfügig über die Führungstischebene (60) hinausragend gehalten sind.

5. Vorrichtung nach Anspruch 4, dadurch gekennzeichnet, daß der Führungstisch (78, 80) auf seiner der Transportebene zugewandten Seite wenigstens einen über seine gesamte Breite reichenden Rücksprung (86, 88) umfaßt, der, in Transportrichtung gesehen, einer der Ausnehmungen (74) nachfolgend angeordnet ist, daß insbesondere mehrere Rücksprünge (86, 88) sägezahnartig ausgebildet sind und eine stufenartige Rücksetzung bzgl. der Transportebene sich im wesentlichen direkt an die in Transportrichtung vorhergehende Ausnehmung (74) anschließt sowie eine an die Stufe anschließende flach ansteigende Fläche in Richtung Transportebene führt, und daß vorzugsweise zwischen aufeinander folgenden Ausnehmungen (74) nur ein Rücksprung (86, 88) angeordnet ist.

6. Vorrichtung nach Anspruch 4 oder 5, dadurch gekennzeichnet, daß der Führungstisch (52) als Führungsglied zur Führung oberhalb und unterhalb der Transportebene ausgebildet ist, daß insbesondere der Abstand der Ausnehmungen (74) bei dem unterhalb der Transportebene angeordneten Führungstisch (80) kleiner ist als bei dem oberhalb der Führungsebene angeordneten Führungstisch (78), und daß vorzugsweise der Abstand der Ausnehmungen (74) des jeweils oberhalb der Transportebene angeordneten Führungstisches (78) etwa doppelt so groß ist wie der Abstand in dem jeweils unterhalb der Transportebene angeordneten Führungstisch (80) und/oder daß die Ausnehmungen (74) des oberhalb der Transportebene angeordneten Führungstisches (78) im wesentlichen auf Ausnehmungen (74) in dem unterhalb angeordneten Führungstisch (80) ausgerichtet sind, so daß die Rollen (58) in Ausnehmungen (74) im wesentlichen parallele, sich bzgl. der Transportebene gegenüberliegend in einer gemeinsamen vertikalen Ebene angeordnete Drehachsen aufweisen.

7. Vorrichtung nach einem der Ansprüche 4 bis 6, dadurch gekennzeichnet, daß zumindest Teile von in Ausnehmungen (74) wenigstens eines unteren Führungstisches (80) angeordneten Rollen (58) antreibbar sind, daß insbesondere die, Ausnehmungen (74) zugehörenden, Öffnungen (76) in der der Transportebene zugewandten Seite (60) des jeweiligen Führungstisches (52) so bemessen sind, daß bei eingesetzten Rollen (58) nur noch relativ kleine Spalten zwischen den Rollen (58) und dem Führungstisch (52) verbleiben, daß vorzugsweise die Breite der Umfangsfläche der jeweiligen Rolle (58) kleiner ist als die Breite des Führungstisches (52) und/oder daß die Umfangsfläche der jeweils in einer Ausnehmung (74) des Führungstisches (52) angeordneten Rolle regelmäßige Erhebungen aufweist bzw. die Rollen der Führungstische (78, 80) in wechselnden Abständen von der Mitte des Transportweges angeordnet sind.

8. Vorrichtung nach einem der Ansprüche 4 bis 7, dadurch gekennzeichnet, daß die Rollen in dem Führungstisch in regelmäßigen Abständen entlang des Transportweges angeordent sind.

9. Vorrichtung nach einem der vorhergehenden Ansprüche, dadurch gekennzeichnet, daß mindestens ein oberhalb der Transportebene angeordnetes Führungselement (18, 18a) in Abhängigkeit von der Dicke der zu behandelnden Gegenstände (26) anhebbar ist, und daß insbesondere der seitliche Abstand des Führungselementes (18, 19) zur Transportmitte einstellbar ist.

10. Vorrichtung nach einem der vorhergehenden Ansprüche, dadurch gekennzeichnet, daß die Vorrichtung (10) mindestens eine stehende Welle umfaßt, welche das flüssige Behandlungsmedium stetig gegen eine Oberfläche der Gegenstände (26) fördert, daß insbesondere eine stehende Welle als kontinuierlich überlaufendes und kontinuierlich wiederaufgefülltes Bad ausgebildet ist, und daß vorzugsweise das jeweilige Führungselement (18, 19) eine seitliche Begrenzung des Badinhaltes definiert und zwischen sich und einem durchlaufenden Gegenstand (26) einen oder mehrere Austrittsöffnungen für das Behandlungsmedium schafft.

11. Vorrichtung nach einem der vorhergehenden Ansprüche, dadurch gekennzeichnet, daß die Transportvorrichtung an ihrem einlaufseitigen Ende Führungen (90, 91) umfaßt, welche beiderseits des Transportweges angeordnet sind und oberhalb sowie unterhalb der Transportebene paarweise Führungsflächen umfassen, die eine keilförmige Aufnahme für die in die Vorrichtung (10) einlaufenden Gegenstände bilden, wobei vorzugsweise die keilförmige Aufnahme aus dem Gehäuse (12) der Vorrichtung (10) hervorstehend angeordnet ist.

12. Vorrichtung nach einem der Ansprüche 1 bis 3, dadurch gekennzeichnet, daß die Transportebene zwischen den beiderseits des Transportweges angeordneten Führungselementen (18, 19) mittels einer Rollenbahn definiert ist, daß insbesondere die Rollen der Rollenbahn in Reihen quer zum Transportweg bzw. die Rollen der einen Reihe bzgl. der Rollen der in Transportrichtung vorhergehenden Reihe seitlich versetzt angeordnet sind und daß insbesondere die durch die Rollenbahn definierte Ebene geringfügig tiefer angeordnet ist als die durch die Zugehörige Führungseinrichtung (18, 19) definierte Führungsebene.

13. Vorrichtung nach einem der vorhergehenden Ansprüche, dadurch gekennzeichnet, daß die Führungselemente beiderseits des Transportweges angeordnet sind.

14. Vorrichtung nach Anspruch 1 und 4, dadurch gekennzeichnet, daß die Führungselemente eine Kombination von unterhalb der Transportebene angeordnetem Führungstisch (52) mit Rollen (58) und oberhalb der Transportebene angeordnetem Band (20, 21) aufweisen.

## Claims

1. Apparatus for the treatment of board-like articles (26), in particular printed circuit boards, with a liquid treatment medium, particularly a cleaning, etching, metallizing or rinsing liquid, along a substantially horizontal conveying path, which is defined by a conveying means with the associated conveying movement, the conveying means comprising guide elements (18, 19 or 18a) guiding the articles (26) in the treatment area on either side of the conveying plane, characterized in that the guide elements (18, 19) comprise at least one continuously revolving belt (20, 21), whose upper or lower strand (23, 24) covers or engages at least one marginal area of the articles (26) running parallel to the longitudinal edges.

2. Apparatus according to claim 1, characterized in that the belt (20, 21) is drivable and that in particular belts (20, 21) are arranged above and below the conveying plane and that preferably the width of the belts (20, 21) is dimensioned in such a way that they only cover and engage marginal areas of the articles (26) not to be treated and/or that the belts (20, 21) with their strand (23, 24) facing the conveying plane extend substantially over the entire conveying path within the apparatus (10) or that the belts (20, 21) are only laterally guided on their strand remote from the conveying plane.

3. Apparatus according to claim 1 or 2, characterized in that the belt (20, 21) is a glass fibre-reinforced Teflon belt and/or that the belt (20, 21) is supported by rolls (32) on its strand (23, 24) adjacent to the conveying plane or the width of the belt (20, 21) is equal to or smaller than the width of the circumferential surface of the rolls (32).

4. Apparatus according to the preamble of claim 1, characterized in that the guide elements (18, 19) have an elongated guide table (52) for guiding the leading edges of the articles positioned below and/or above the conveying plane and which contains in recesses (74) open to the conveying plane rolls (58), which are rotatable and are held with their circumferential surface projecting only slightly over the guide table plane (60).

5. Apparatus according to claim 4, characterized in that on its side facing the conveying plane the guide table (78, 80) has at least one offset (86, 88) extending over its entire width and which, considered in the conveying direction, follows one of the recesses (74), that in particular several offsets (86, 88) are constructed in sawtooth-like manner and a step-like setting back with respect to the conveying plane substantially directly connects on to the preceding recess (74) in the conveying direction and guides a shallow rising surface in the direction of the conveying plane connecting on to the step and that preferably between successive recesses (74) there is only one offset (86, 88).

6. Apparatus according to claim 4 or 5, characterized in that the guide table (52) is constructed as a guide member for guidance above and below the conveying plane, that in particular the spacing of the recesses (74) with the guide table (80) arranged below the conveying plane is smaller than when the guide table (78) is located above the guide plane and that preferably the spacing of the recesses (74) of the guide table (78) above the conveying plane is roughly twice as large as the spacing in the guide table (80) below the conveying plane and/or that the recesses (74) of the guide table (78) above the conveying plane are oriented substantially towards recesses (74) in the guide table (80) positioned below the same, so that the rolls (58) in the recesses (74) have substantially parallel rotation axes located in a common vertical plane facing the conveying plane.

7. Apparatus according to one of the claims 4 to 6, characterized in that at least parts of rolls (58) located in recesses (74) of at least a lower guide table (80) are drivable, that in particular the openings (76) associated with the recesses (74) in the side (60) of the guide table (52) facing the conveying plane are so dimensioned that when the rolls (58) are inserted only relatively small gaps remain between the rolls (58) and the guide table (52), that preferably the width of the circumferential surface of the particular roll (58) is smaller than the width of the guide table (52) and/or that the circumferential surface of the roll arranged in a recess (74) of the guide table (52) has regular protuberances or the rolls of the guide tables (78, 80) are arranged in varying spacings from the centre of the conveying path.

8. Apparatus according to one of the claims 4 to 7, characterized in that the rolls are arranged in the guide table at regular intervals along the conveying path.

9. Apparatus according to one of the preceding claims, characterized in that at least one guide element (18, 18a) arranged above the conveying plane is raisable as a function of the thickness of the articles (26) to be treated and that in particular the lateral spacing of the guide element (18, 19) towards the conveying centre is adjustable.

10. Apparatus according to one of the preceding claims, characterized in that the apparatus (10) has at least one stationary wave, which conveys the liquid treatment medium constantly against a surface of the articles (26), that in particular a stationary wave is constructed as a continuously overflowina and continuously refilled bath and that preferably the guide element (18, 19) defines a lateral boundary of the bath content and between it and a passing through article (26) creates one or more outlets for the treatment medium.

11. Apparatus according to one of the preceding claims, characterized in that the conveying means has on its inlet-side end guides (90, 91) arranged on either side of the conveying path and above and below the conveying plane comprise pairwise guide surfaces, which form a wedge-like receptacle for the articles entering the means (10) and preferably the wedge-shaped receptacle projects from the casing (12) of the means (10).

12. Apparatus according to one of the claims 1 to 3, characterized in that the conveying plane is defined between the guide elements (18, 19) on either side of the conveying path by means of a roll train, that in particular the rolls of the roll train in rows transversely to the conveying path or the rolls of one row are laterally displaced with respect to the rolls of the preceding row in the conveying direction and that in particular the plane defined by the roll train is positioned slightly deeper than the guide plane defined by the associated guide mechanism (18, 19).

13. Apparatus according to one of the preceding claims, characterized in that the guide elements are positioned on either side of the conveying path.

14. Apparatus according to claim 1 and 4, characterized in that the guide elements have a combination of a guide table (52) with rolls (58) arranged below the conveying plane and a belt (20, 21) arranged above the conveying plane.

## Revendications

1. Dispositif pour traiter des objets en forme de plaques (26), et en particulier des cartes pour circuits imprimés, au moyen d'un produit de traitement liquide, comme un liquide de nettoyage, d'attaque, de métallisation et/ou de rinçage, dans la région d'un trajet de transport qui est en particulier horizontal pour l'essentiel et qui est défini par un dispositif transporteur auquel est associé un déplacement de transport, le dispositif transporteur comprenant des éléments de guidage (18, 19, respectivement 18a) qui guident les objets (26) des deux côtés du plan de transport dans la zone de traitement, caractérisé par le fait que les éléments de guidage (18, 19) comprennent au moins une bande sans fin en défilement (20, 21), laquelle recouvre et saisit par ses brins supérieur et inférieur (23, 24) au moins une zone de bord des objets (26) qui s'étend parallèlement aux bords longitudinaux.

2. Dispositif selon la revendication 1, caractérisé par le fait que la bande (20, 21) peut être entraînée, par le fait qu'en particulier des bandes (20, 21) sont disposées au-dessus et au-dessous du plan de transport, et par le fait que, de préférence, la largeur des bandes (20, 21) est calculée d'une manière telle qu'elles ne recouvrent et ne saisissent que des zones de bord des objets (26) qui ne sont pas à traiter et/ou par le fait que les bandes (20, 21) s'étendent, à l'intérieur du dispositif (10), pour l'essentiel sur la totalité du trajet de transport par leur brin (23, 24) qui est tourné vers le plan de transport, ou, respectivement, par le fait que les bandes (20, 21) ne sont guidées latéralement que sur leur brin qui est opposé au plan de transport.

3. Dispositif selon la revendication 1 ou 2, caractérisé par le fait que la bande (20, 21) est une bande en Téflon renforcée par des fibres de verre et/ou par le fait que la bande (20, 21) est supportée par des rouleaux (32) du côté de son brin (23, 24) qui est voisin du plan de transport, ou, respectivement, que la largeur de la bande (20, 21) est inférieure ou égale à la largeur de la surface du pourtour des rouleaux (32).

4. Dispositif selon le préambule de la revendication 1, caractérisé par le fait que les éléments de guidage (18, 19) présentent une table de guidage (52) qui s'étend d'une manière allongée au-dessous et/ou au-dessus du plan de transport, qui est destinée au guidage des bords avant des objets et qui présente, dans des évidements (74) ouverts dans la direction du plan de transport, des rouleaux (58) maintenus en rotation dont la surface du pourtour ne fait saillie que légèrement au-delà du plan (60) de la table de guidage.

5. Dispositif selon la revendication 4, caractérisé par le fait que la table de guidage (78, 80) comporte, sur son côté tourné vers le plan de transport, au moins une partie en retrait (86, 88) qui s'étend sur toute sa largeur et qui, vue dans la direction du transport, est disposée à la suite de l'un des évidements (74), par le fait qu'en particulier plusieurs parties en retrait (86, 88) sont conformées en dents de scie, qu'un retour en forme de gradin par rapport au plan de transport se raccorde pour l'essentiel directement à l'évidement (74) qui est à l'avant dans la direction du transport, et qu'une surface qui se raccorde au gradin monte avec une faible pente dans la direction du plan de transport, et par le fait que, de préférence, une seule partie en retrait (86, 88) est disposée entre des évidements consécutifs (74).

6. Dispositif selon la revendication 4 ou 5, caractérisé par le fait que la table de guidage (52) est réalisée sous la forme d'un organe de guidage en vue du guidage au-dessus et au-dessous du plan de transport, par le fait qu'en particulier, la distance entre les évidements (74) est plus faible dans le cas de la table de guidage (80) qui est disposée au-dessous du plan de transport que dans le cas de la table de guidage (78) qui est disposée au-dessus du plan de guidage, et par le fait que, de préférence, la distance entre les évidements (74) de la table de guidage (78) qui est disposée à chaque fois au-dessus du plan de transport est à peu près le double de la distance dans la table de guidage (80) qui est disposée à chaque fois au-dessous du plan de transport et/ou par le fait que les évidements (74) de la table de guidage (78) qui est disposée au-dessus du plan de transport sont alignés pour l'essentiel sur des évidements (74) ménagés dans la table de guidage (80) qui est disposée au-dessous, de sorte que les rouleaux (58) situés dans des évidements (74) présentent des axes de rotation qui sont parallèles pour l'essentiel et qui sont disposés dans un plan vertical commun en se faisant face par rapport au plan de transport.

7. Dispositif selon l'une des revendications 4 à 6, caractérisé par le fait qu'au moins des parties de rouleaux (58) disposées dans des évidements (74) d'au moins une table de guidage inférieure (80) peuvent être entraînées, par le fait qu'en particulier, des ouvertures (76) appartenant aux évidements (74) dans le côté (60) de la table de guidage correspondante (52) qui est tourné vers le plan de transport sont dimensionnées d'une manière telle qu'il ne reste plus que des interstices relativement faibles entre les rouleaux (58) et la table de guidage (52) lorsque les rouleaux (58) sont insérés, par le fait que, de préférence, la largeur de la surface du pourtour du rouleau correspondant (58) est inférieure à la largeur de la table de guidage (52) et/ou par le fait que la surface du pourtour du rouleau qui est à chaque fois disposé dans un évidement (74) de la table de guidage (52) présente des surélévations régulières ou, respectivement, que les rouleaux des tables de guidage (78, 80) sont disposés à des distances alternées par rapport au milieu du trajet de transport.

8. Dispositif selon l'une des revendications 4 à 7, caractérisé par le fait que les rouleaux sont disposés dans la table de guidage à des distances régulières le long du trajet de transport.

9. Dispositif selon l'une des revendications précédentes, caractérisé par le fait qu'au moins un élément de guidage (18, 18a) disposé au-dessus du plan de transport peut être soulevé en fonction de l'épaisseur des objets à traiter (26), et par le fait que l'on peut régler en particulier la distance dans le sens latéral de l'élément de guidage (18, 19) par rapport au milieu du trajet de transport.

10. Dispositif selon l'une des revendications précédentes, caractérisé par le fait que le dispositif (10) comprend au moins une quantité permanente de liquide qui envoie constamment le produit de traitement liquide sur une surface des objets (26), par le fait qu'en particulier, une quantité permanente de liquide est réalisée sous la forme d'un bain qui déborde en continu et qui est à nouveau rempli en continu, et par le fait que, de préférence, l'élément de guidage correspondant (18, 19) définit une délimitation latérale du contenu du bain et crée entre lui et un objet en défilement (26) une ou plusieurs ouvertures de sortie destinées au produit de traitement.

11. Dispositif selon l'une des revendications précédentes, caractérisé par le fait que le dispositif transporteur comprend, à son extrémité située du côté de l'entrée, des guidages (90, 91) qui sont disposés des deux côtés du trajet de transport et qui comprennent par paires, au-dessus et au-dessous du plan de transport, des surfaces de guidage constituant un logement en forme de coin pour les objets qui entrent dans le dispositif (10), le logement en forme de coin étant de préférence disposé en saillie hors du carter (12) du dispositif (10).

12. Dispositif selon l'une des revendications 1 à 3, caractérisé par le fait que le plan de transport est défini au moyen d'un transporteur à rouleaux entre les éléments de guidage (18, 19) disposés des deux côtés du trajet de transport, par le fait qu'en particulier, les rouleaux du transporteur à rouleaux sont disposés selon des rangées transversales par rapport au trajet de transport ou, respectivement, que les rouleaux de l'une des rangées sont disposés en étant décalés latéralement par rapport aux rouleaux de la rangée qui précède dans la direction du transport, et par le fait qu'en particulier, le plan défini par le transporteur à rouleaux est disposé légèrement plus bas que le plan de guidage défini par le dispositif de guidage associé (18, 19).

13. Dispositif selon l'une des revendications précédentes, caractérisé par le fait que les éléments de guidage sont disposés des deux côtés du trajet de transport.

14. Dispositif selon les revendications et 4, caractérisé par le fait que les éléments de guidage présentent une combinaison d'une table de guidage (52) disposée au-dessous du plan de transport et pourvue de rouleaux (58), et d'une bande (20, 21) disposée au-dessus du plan de transport.
